# EUROPEAN PATENT APPLICATION

(11) **EP 2 172 702 A1**
(43) Date of publication of application: **07.04.2010**
(21) Application number: 07721554.9
(22) Date of filing: 25.06.2007
(51) Int. Cl.: F21V 29/00, H01L 33/00, H01L 23/373, H01L 25/075, F21Y 101/02

(54) **A LIGHT-EMITTING DIODE LIGHTING DEVICE**

(71) Applicant: NeoBulb Technologies, Inc., Bandar Seri Begawan (BN)
(72) Inventor: NeoBulb Technologies, Inc., Bandar Seri Begawan (BN)
(74) Representative: Goddar, Heinz J.
(86) International application number: PCT/CN2007/001981
(87) International publication number: WO 2009/000105

(57) **Abstract**

The invention provides a light-emitting diode illuminating apparatus. The light-emitting diode illuminating apparatus includes a carrier, a substrate, a light-emitting diode chip, a heat-conducting device, and a thermal phase-change material. The carrier includes a top surface and a bottom surface. A first recess is formed on the top surface of the carrier. A second recess is formed on the bottom surface of the carrier. The first recess communicates with the second recess. The substrate is embedded into the second recess. The light-emitting diode chip is disposed on the substrate. The heat-conducting device includes a flat part. And, the substrate is disposed on the flat part.

## Description

### BACKGROUND OF THE INVENTION

### 1. Field of the invention

The invention relates to a light-emitting diode illuminating apparatus, and particularly to a light-emitting diode illuminating apparatus including a substrate adhered by a thermal phase-change material.

### 2. Description of the prior art

Along with the development of the semiconductor light-emitting devices, a light-emitting diode has become a newly developed light source with several advantages, including low power-consumption, shock-proof, quick responding, and suitable for mass production. As a result, a LED is usually used for an indicator and serves as a light source of an illuminating product. However, in order to supply sufficient illumination, most illuminating products utilize high-power LEDs, and the demand of high heat-dissipating efficiency is then required.

Generally, a LED is disposed on a substrate, and the substrate is then disposed on a heat-dissipating device. The heat-dissipating device can be a metal plate, a heat-pipe with high heat-guiding efficiency, or other materials for providing high heat-guiding efficiency, on which several fins for raising a heat-dissipating efficiency are disposed. Because the heat generated from the LED in operation needs to be conducted to the heat-dissipating device via the substrate, the interface heat-resistance between the LED and the substrate or between the substrate and the heat-dissipating device has been an important issue. In prior art, because the volume of LED is much smaller than the substrate, and most LEDs are directly formed or stuck on the substrate, the reduction of the interface heat-resistance between the LED and the substrate is then limited. Therefore, the main focus of improving the whole system is placed on reduction of the interface heat-resistance between the substrate and the heat-dissipating device.

Since the substrate and the heat-dissipating device can not be stuck tightly, there are many air-cells generated between the substrate and the heat-dissipating device. And, because the volume of the air-cell is small, the efficiency of thermo-convection becomes very low, and then the heat conduction plays a major role of the heat transfer. Besides, since the heat-conduction efficiency of air is very low, the interface heat-resistance between the substrate and the heat-dissipating device becomes overly high. In prior art, a gap between the substrate and the heat-dissipating device is mostly filled with heat-conducting material such as a heat-dissipating cream. Accordingly, air-cells will not be formed, and the interface heat-resistance is then lowered. However, if high temperature is lasted for a long time, the heat-dissipating cream will become harden, and the fluidity of the heat-dissipating cream will become highly lowered as well. Alternatively, the effect of the filling air-cells will be reduced, and the air-cells will be formed to increase the interface heat-resistance. In a bad situation, the heat-dissipating device will not effectively conduct or dissipate heat, and the LED will become damaged because of overheating.

Therefore, it is required to offer a LED illuminating apparatus whose filled material for the gap between the substrate and the heat-dissipating device can resist hardening effect, and the filled material can continuously provide a low interface heat-resistance to solve the aforesaid problems.

### SUMMARY OF THE INVENTION

A scope of the invention is to provide a LED illuminating apparatus.

Another scope of the invention is to provide a LED illuminating apparatus including a substrate adhered by a thermal phase-change material.

The LED illuminating apparatus of the invention includes a carrier, a substrate, a first LED chip, a heat-conducting device, and a thermal phase-change material. The carrier includes a partition part, a top surface, and a bottom surface; besides, a first recess is formed on the top surface, a second recess is formed on the bottom surface, and the first recess communicates with the second recess. The substrate is embedded into the second recess. The first LED chip is disposed on the substrate. The heat-conducting device includes a flat part, and the substrate is disposed on the flat part. The thermal phase-change material is disposed between the flat part and the substrate.

The LED illuminating apparatus further includes a support, and the carrier is fixed onto the heat-conducting device by the support. Besides, the substrate includes a bottom surface, and the bottom surface of the substrate and the bottom surface of the carrier are substantially parallel. Therefore, a gap between the substrate and the flat part can be easily and sufficiently filled with the thermal phase-change material, and the heat-conducting efficiency between the substrate and the heat-conducting material can be raised.

Besides, a gap between the substrate and the second recess can be filled with glue to raise the adhesiveness between the substrate and the second recess. A diameter of the first recess is smaller than a diameter of the second recess, so the second recess includes a top part, and the substrate is connected or electrically connected to the top part. In an embodiment, a circuit contact is configured on the substrate, and a circuit contact is correspondingly configured on the top part. When the substrate is connected to the top part, the circuit contact of the substrate is electrically connected to the circuit contact of the top part.

Therein, the carrier can be a low temperature co-fired ceramics (LTCC) plate, a printed circuit board, or a metal-core circuit board. The substrate can be a silicon material, a metal material, or a LTCC material. The first LED chip is a semiconductor LED or a semiconductor laser. The heat-conducting device is a heat pipe or a heat column. The thermal phase-change material has stickiness, so the substrate can be effectively stuck to the flat part. And, the thermal phase-change material has a phase-change temperature. When the phase change of the thermal phase-change material is triggered, the fluidity is raised. Then, the gap between the substrate and the flat part is effectively filled with the thermal phase-change material to avoiding the formation of air-cells. And, the heat generated by the first LED chip in operation can be effectively conducted to and dissipated by the heat-conducting device. In an embodiment, the thermal phase-change material has a phase-change temperature from 40°C to 60°C and has a heat-conducting coefficient from 3.6W/mK to 4.0W/mK.

Additionally, the LED illuminating apparatus of the invention can further include a second LED chip disposed on the substrate. The carrier includes a partition part, and the first LED chip and the second LED chip are separated by the partition part. The first LED chip can emit a light with a first wavelength, the second LED chip can emit a light with a second wavelength, and the fist wavelength is different from the second wavelength. By means of the partition part separating the first LED chip and the second LED chip, the LED illuminating apparatus can simultaneously emit light with different wavelengths. In addition, the LED illuminating apparatus can further include a packaging material. The packaging material simultaneously covers the first LED chip, the second LED chip, and the partition part. In an embodiment, the packaging material includes a fluorescent powder.

In an embodiment, the LED illuminating apparatus of the invention further includes a first fluorescent powder area and a second fluorescent powder area. The first fluorescent powder area is above the first LED chip, and is used for converting a light with a third wavelength emitted from the first LED chip to a light with a fourth wavelength. The second fluorescent powder area is above the second LED chip, and is used for converting a light with a fifth wavelength emitted from the second LED chip to a light with a sixth wavelength. Additionally, the packaging material simultaneously covers the first fluorescent powder area and the second fluorescent powder area, and the powder of the first fluorescent powder area is different from the powder of the second fluorescent powder area. Accordingly, the LED illuminating apparatus can simultaneously emit a bright light with different wavelengths.

In addition, in order to raise the efficiency of light-collection, a lens can be disposed above the packaging material and a reflective layer can be disposed on the first recess of the LED illuminating apparatus of the invention.

Therefore, the LED illuminating apparatus of the invention utilizes the thermal phase-change material to help the substrate to stick to the flat part. After the phase-changing of the thermal phase-change material, the fluidity is raised, and the gap between the substrate and the flat part can be effectively filled with the thermal phase-change material. The thermal phase-change material can keep the fluidity and the thermal conductivity over a long time. Besides, according to the LED illuminating apparatus of the invention, a partition part is disposed between the first LED chip and the second LED chip to integrate multiple LED chips in one single package area. Further, since the package area is shrunk, the LED illuminating apparatus of the invention is capable of simultaneously emitting light with different wavelengths.

The advantage and spirit of the invention may be understood by the following recitations together with the appended drawings.

### BRIEF DESCRIPTION OF THE APPENDED DRAWINGS

FIG. 1A is a cross-section of the LED illuminating apparatus according to a first preferred embodiment of the invention.
FIG. 1B is a local enlarged view of FIG. 1A.
FIG. 1C is another schematic structure diagram illustrating the support of the LED illuminating apparatus of the invention.
FIG. 1D is a schematic diagram illustrating the LED illuminating apparatus of the invention including multiple substrates and multiple LED chips.
FIG. 1E is another schematic structure diagram illustrating the heat-conducting device of the LED illuminating apparatus of the invention and the fins thereon.
FIG. 2A is a local cross section of the LED illuminating apparatus according to a second embodiment.
FIG. 2B is a local cross section of the LED illuminating apparatus according to a third embodiment.
FIG. 2C is a schematic diagram illustrating the LED illuminating apparatus of the invention including multiple substrates and multiple LED chips.
FIG. 2D is a schematic diagram illustrating the LED illuminating apparatus of the invention including the lens and the reflective layer.

### DETAILED DESCRIPTION OF THE INVENTION

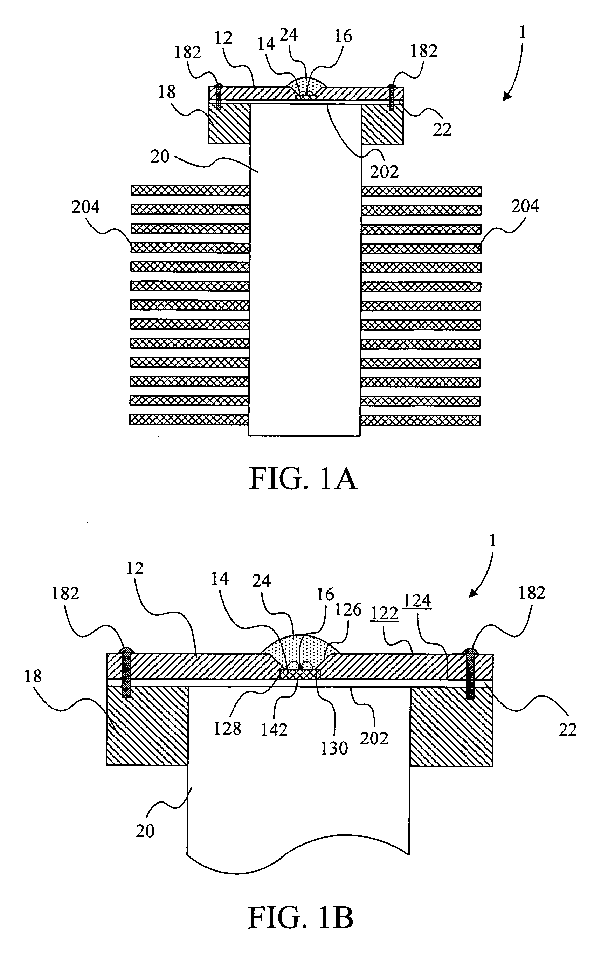

Please refer to FIG. 1A and 1B. FIG. 1A is a cross section of a first preferred embodiment of the LED illuminating apparatus 1 of the invention. FIG. 1B is a local enlarged view of FIG. 1A. The LED illuminating apparatus 1 of the invention includes a carrier 12, a substrate 14, a first LED chip 16, a support 18, a heat-conducting device 20, and a thermal phase-change material 22.

The carrier 12 includes a top surface 122 and a bottom surface 124. A first recess 126 is formed on the top surface 122 of the carrier 12, and a second recess 128 is formed on the bottom surface 124 of the carrier 12. The first recess 126 communicates with the second recess 128. The substrate 14 is embedded into the second recess 128. The first LED chip 16 is disposed on the substrate 14. Besides, the diameter of the first recess 126 is smaller than the diameter of the second recess 128, so the second recess 128 has a top part 130. The substrate 14 is connected to the top part 130. The top part 130 is capable of blocking the substrate and increasing the contact area between the substrate 14 and the second recess 128. Alternatively, the top part 130 enhances the adhesion between the substrate 14 and the second recess 128. Besides, in an embodiment, a circuit contact (not shown) can be configured on the substrate 14, and another circuit contact (not shown) can be correspondingly configured on the top part 130. When the substrate 14 is connected to the top part 130, the circuit contact of the substrate 14 is electrically connected to the circuit contact of the top part 130. In this situation, the first LED chip 16 does not need to be wired to the carrier 12.

Additionally, the support 18 has a hole (not marked), so the support 18 can be fixed on the heat-conducting device 20. The heat-conducting device 20 includes a flat part 202. The thermal phase-change material 22 is disposed on the flat part 202, and then the substrate 14 is disposed on the thermal phase-change material 22. The gap between the substrate 14 and the flat part 202 can be filled with the thermal phase-change material 22, so the interface heat-resistance between the substrate 14 and the flat part 202 can be reduced. Because the second recess is embedded into the substrate 14, the goal of fixing the substrate 14 can be achieved by the fixing of the carrier 12. As shown in FIG. 1B, the support 18 fixes the carrier 12 onto the heat-conducting device 20 via several screws 182, therefore the substrate 14 can be fixed on the flat part 202 by compressing the thermal phase-change material 22. Because a bottom surface 142 of the substrate 14 and a bottom surface 142 of the carrier 124 are coplanar, a gap between the substrate 14 and the flat part 202 can be fully filled with the thermal phase-change material 22.

According to the first embodiment, the phase-change material 22 has a phase-change temperature from 40°C to 60°C, but the invention is not limited to this. After the phase-change of the thermal phase-change material 22 is triggered, the fluidity is raised. Therefore a gap between the substrate 14 and the flat part 202 can be effectively filled with the thermal phase-change material 22 to avoid the formation of air-cells. The heat generated by the first LED chip 16 in operation can be conducted to and dissipated by the heat-conducting device 20. The thermal phase-change material 22 has a heat-conducting efficiency from 3.6W/mK to 4.0W/mK. Besides, the heat-conducting device 20 can includes several fins 204(as shown in FIG. 1A) for dissipating the heat conducted from the flat part 202. The configuration of the fins 204 depends on the design of the product, and it will not be described here again.

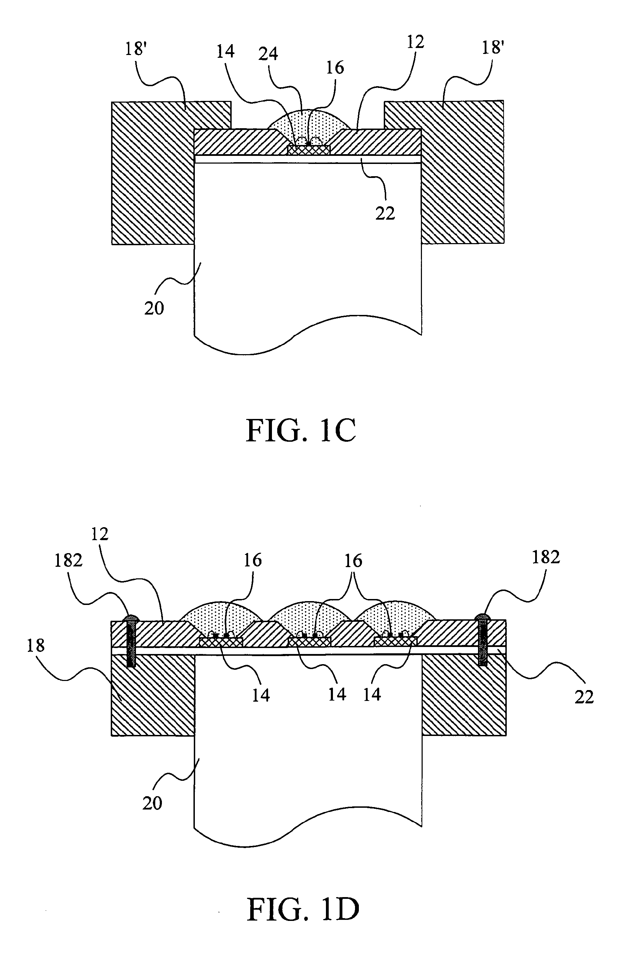

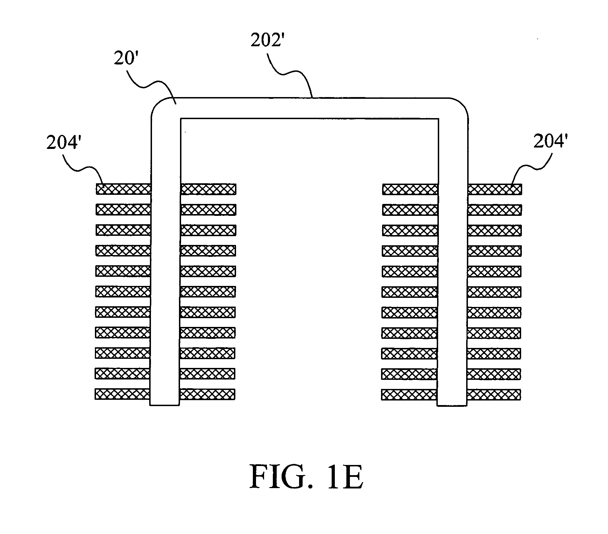

It should be remarked that, as shown in FIG. 1B, the whole carrier 12 is disposed on the thermal phase-change material 22, but the invention is not limited to this. Besides, the way that the support 18 fixes the carrier 12 is not limited to the one shown in FIG. 1B. For example, the support 18' can be stuck with the carrier 12 in structure, as shown in FIG. 1C. It is certain that the aforesaid two fixing methods shown in FIG. 1B and FIG. 1C can be combined. Additionally, according to the first embodiment, the LED illuminating apparatus 1 merely includes one substrate 14 and one LED chip 16, but the invention is not limited to this. Alternatively, the LED illuminating apparatus of the invention also can include several substrates 14, and several LED chips 16 are disposed on each of the substrates 14, as shown in FIG. 1D. Besides, the flat part 202 is not necessarily located at the terminal surface of the heat-conducting device 20. The flat part 202' also can be formed in a middle part of the pipe of the heat-conducting device 20'. As shown in FIG. 1E (FIG. 1E only illustrates the heat-conducting device 20' and the fins 204'), the heat-conducting device 20' can be a U-shaped pipe, and the middle part is squashed to form the flat part 202'. The fins 204' can be configured on two terminals of the heat-conducting device 20'. In this situation, the support 18 needs to be correspondingly modified in structure; therefore, the support 18 can fix the carrier 12 on the heat-conducting device 20', and the substrate 14 can be disposed on the flat part 202'.

According to the invention, the carrier 12 can be a low temperature co-fired ceramics (LTCC) plate, a printed circuit board, a metal-core circuit board or other material capable of engaging to the substrate 14. The substrate 14 can be a silicon material, a metal material, a LTCC material, or other material capable of mounting the LED chip. The gap between the substrate 14 and the second recess 130 can be filled with glue to enhance the adhesion. The first LED chip 16 is a semiconductor LED or a semiconductor laser.

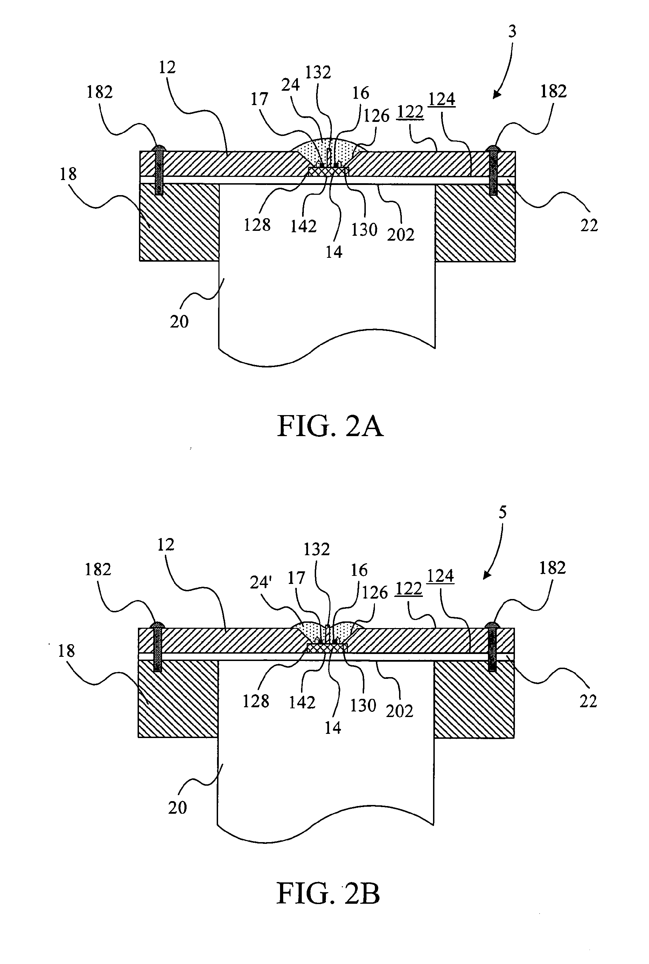

Please refer to FIG. 2A, FIG. 2A is a local cross-section of the LED illuminating 3 according to a second preferred embodiment of the invention. Compared with the LED illuminating apparatus 1 of the first embodiment, the LED illuminating apparatus 3 further includes a second LED chip 17, and the carrier 12 includes a partition part 132. The second LED chip 17 is disposed on the substrate 14. The first LED chip 16 and the second LED chip 17 are separated by the partition part 132.

The first LED chip 16 can emit a light with a first wavelength, the second LED chip 17 can emit a light with a second wavelength, and the first wavelength is different from the second wavelength. By means of the partition part 132 separating the first LED chip 16 and the second LED chip 17, the LED illuminating apparatus 3 can simultaneously emit light with different wavelengths. Besides, the LED illuminating apparatus 3 further includes a packaging material 24. The packaging material 24 simultaneously covers the first LED chip 16, the second LED chip 17, and the partition part 132. In an embodiment, the packaging material 24 includes a fluorescent powder. It should be remarked that the description of the packaging material 24 is suitable for the first embodiment.

Please refer to FIG. 2B, FIG. 2B is a local cross-section of the LED illuminating apparatus 5 according to a third embodiment of the invention. Compared with the second embodiment, the LED illuminating apparatus 5 further includes a first fluorescent powder area and a second fluorescent powder area (both not shown). The first fluorescent powder area is disposed above the first LED chip 16, and is used for converting a light with a third wavelength emitted from the first LED chip 16 to a light with a fourth wavelength. The second fluorescent powder area is disposed above the second LED chip 16, and is used for converting a light with a fifth wavelength emitted from the second LED chip 16 to a light with a sixth wavelength. Besides, the packaging material 24' covers the first fluorescent powder area and the second fluorescent powder area, and the fluorescent powder of the first fluorescent powder area is different from the fluorescent powder of the second fluorescent powder area. Therefore, even if the third wavelength is the same as the fifth wavelength, the fourth wavelength can be different from the sixth wavelength because of different fluorescent powders. Accordingly, the LED illuminating apparatus 5 can simultaneously emit bright light with different wavelengths.

According to the LED illuminating apparatus 5, the packaging material 24' independently covers the first LED chip 16 and the second LED chip 17. Therefore, in the embodiment, the packaging material 24' of the first fluorescent powder area can includes a fluorescent powder for converting a light with a fourth wavelength to a light with a seventh wavelength. Similarly, the packaging material 24' of the second fluorescent powder area can include another fluorescent powder for converting a light with a sixth wavelength to a light with an eighth wavelength. Accordingly, even if the fourth wavelength is the same as the sixth wavelength, the LED illuminating apparatus 5 can emit light with different wavelengths by adjusting the fluorescent powder of the packaging material 24'.

It should be remarked that the packaging material 24' of the LED illuminating apparatus 5 does not cover the partition part 132, so the light emitted from the first LED chip 16 does not interfere with the light emitted from the second LED chip 17. Accordingly, the LED illuminating apparatus 5 can simultaneously emit bright light with different wavelengths. Contrarily, the packaging material 24 of the LED illuminating apparatus 3 covers the partition part 132, so the light emitted from the first LED chip 16 is partially mixed with the light emitted from the second LED chip 17, and further a softness effect is formed. Accordingly, the LED illuminating apparatus 3 can emit softer light with different wavelengths. Besides, the LED illuminating apparatus of the invention surely emit light with single wavelength, and it will not be described here again.

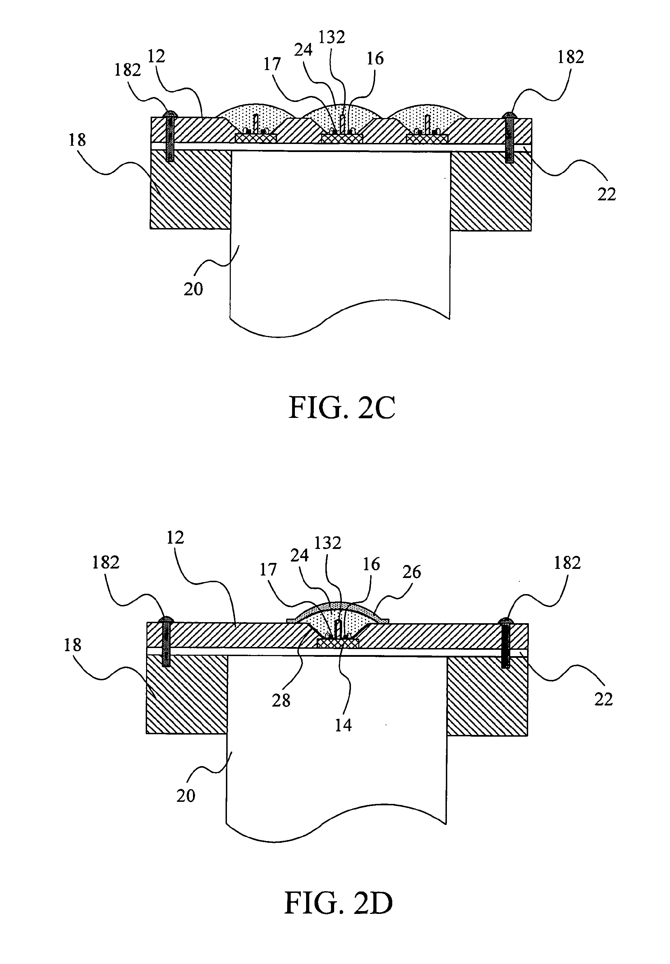

As described in the first embodiment, according to the second or the third embodiment, the LED illuminating apparatus 3 or 5 merely includes one substrate and two LED chips 16 and 17, but the invention is not limited to this. Alternatively, the LED illuminating apparatus of the invention also can include multiple substrates 14, and multiple LED chips 16 and 17 can be disposed on each of the substrates 14, as shown in FIG. 2C. In addition, in order to raise the efficiency of light-collection, as shown in FIG. 2D, a lens 26 can be disposed above the packaging material, and a reflective layer 28 can be disposed on the first recess 126. The lens 26 does not need to be tightly stuck with the packaging material 24 and 24'.

In brief, the LED illuminating apparatus of the invention utilizes the thermal phase-change material to help the substrate to stick to the flat part. After the phase-changing of the thermal phase-change material, the fluidity is raised, and the gap between the substrate and the flat part can be effectively filled with the thermal phase-change material. The thermal phase-change material can keep the fluidity and the thermal conductivity over a long time. Besides, in the LED illuminating apparatus of the invention, a partition part is disposed between the first LED chip and the second LED chip to integrate multiple LED chips in one single package area. Further, the package area is shrunk and the LED illuminating apparatus of the invention is capable of simultaneously emitting light with different wavelengths.

With the example and explanations above, the features and spirits of the invention will be hopefully well described. Those skilled in the art will readily observe that numerous modifications and alterations of the device may be made while retaining the teaching of the invention. Accordingly, the above disclosure should be construed as limited only by the metes and bounds of the appended claims.

## Claims

1. A light-emitting illuminating apparatus, comprising:
a carrier, comprising a top surface and a bottom surface, a first recess being formed on the top surface of the carrier, a second recess being formed on the bottom surface of the carrier, the first recess communicating with the second recess;
a substrate, embedded into the second recess;
a first light-emitting diode chip, disposed on the substrate;
a heat-conducting device, comprising a flat part, the substrate being disposed on the flat part; and
a thermal phase-change material, disposed between the flat part and the substrate.

2. The light-emitting illuminating apparatus of claim 1, further comprising a second light-emitting diode chip disposed on the substrate, wherein the carrier comprises an partition part, and the first light-emitting diode chip and the second light-emitting diode chip are separated by the partition part.

3. The light-emitting illuminating apparatus of claim 2, wherein the first light-emitting diode chip can emit a light with a first wavelength, the second light-emitting diode chip can emit a light with a second wavelength, and the first wavelength is different from the second wavelength.

4. The light-emitting illuminating apparatus of claim 2, further comprising a first fluorescent powder area on the first light-emitting diode chip, the first fluorescent powder area being used for converting a light with a third wavelength emitted from the first light-emitting diode chip to a light with a fourth wavelength.

5. The light-emitting illuminating apparatus of claim 4, further comprising a second fluorescent powder area on the second light-emitting diode chip, the second fluorescent powder area being used for converting a light with a fifth wavelength emitted from the second light-emitting diode chip to a light with a sixth wavelength.

6. The light-emitting illuminating apparatus of claim 5, further comprising a packaging material simultaneously covering the first fluorescent powder area and the second fluorescent powder area, a fluorescent powder of the first fluorescent powder area being different from a fluorescent powder of the second fluorescent powder area.

7. The light-emitting illuminating apparatus of claim 2, further comprising a packaging material simultaneously covering the first light-emitting diode chip, the second light-emitting diode chip, and the partition part.

8. The light-emitting illuminating apparatus of claim 7, wherein the packaging material comprises a fluorescent powder.

9. The light-emitting illuminating apparatus of claim 7, further comprising a lens disposed above the packaging material.

10. The light-emitting illuminating apparatus of claim 1, wherein the carrier is a low temperature co-fired ceramics plate, a printed circuit board, or a metal-core circuit board.

11. The light-emitting illuminating apparatus of claim 1, wherein a diameter of the first recess is smaller than a diameter of the second recess, so that the second recess comprises a top part, and the substrate is connected to the top part.

12. The light-emitting illuminating apparatus of claim 11, wherein the substrate is electrically connected to the top part.

13. The light-emitting illuminating apparatus of claim 1, wherein a gap between the substrate and the second recess is filled with glue.

14. The light-emitting illuminating apparatus of claim 1, further comprising a reflective layer on the first recess.

15. The light-emitting illuminating apparatus of claim 1, wherein the substrate is a silicon material, a metal material, or a LTCC material.

16. The light-emitting illuminating apparatus of claim 1, wherein the first light-emitting diode chip is a semiconductor light-emitting diode or a semiconductor laser.

17. The light-emitting illuminating apparatus of claim 1, wherein the substrate comprises a bottom surface, the bottom surface of the substrate and the bottom surface of the carrier are substantially coplanar.

18. The light-emitting illuminating apparatus of claim 1, further comprising a support fixing the carrier on the heat-conducting device.

19. The light-emitting illuminating apparatus of claim 1, wherein the heat-conducting device is a heat pipe or a heat column.

20. The light-emitting illuminating apparatus of claim 1, wherein the thermal phase-change material has stickiness.

21. The light-emitting illuminating apparatus of claim 1, wherein the thermal phase-change material has a phase-change temperature from 40°C to 60°C.

22. The light-emitting illuminating apparatus of claim 1, wherein the thermal phase-change material has a heat-conducting coefficient from 3.6W/mK to 4.0W/mK.
